# EUROPEAN PATENT SPECIFICATION

(11) **EP 0 320 657 B1**
(45) Date of publication and mention of the grant of the patent: **29.09.1993**
(21) Application number: 88119329.6
(22) Date of filing: 21.11.1988
(51) Int. Cl.: C23C 16/26, C23C 16/02, C30B 29/04, C30B 25/00

(54) **Improved diamond growth process**
Verfahren zur Züchtung von Diamant
Procédé de croissance de diamant

(30) Priority: 17.12.1987 US 134436
(43) Date of publication of application: 21.06.1989
(73) Proprietor: GENERAL ELECTRIC COMPANY, Schenectady New York 12305 (US)
(72) Inventor: Anthony, Thomas Richard, Schenectady, NY 12309 (US); Fleischer, James Fulton, Scotia, NY 12302 (US); Devries, Robert Charles, Burnt Hills, NY 12309 (US)
(74) Representative: Pratt, Richard Wilson

(56) References cited:
- EP-A- 272 418
- US-A- 3 661 526
- US-A- 4 434 188
- PATENT ABSTRACTS OF JAPAN, vol. 9, no. 36 (C-266)[1759], 15 February 1985#

## Description

This invention relates to a chemical vapor deposition process for production of diamond crystals, and more particularly, to an improved process of forming or growing diamond crystals utilizing elemental boron as a diamond crystal nucleation and growth promoter which can be used to control size, growth rate, and positioning of crystals of larger and smaller size.

Reference is made to EP-A-272 418 (state of the art according to Art.54(3)EPC). EP-A-272 418, discloses a chemical vapor deposition method and apparatus by which nucleation of diamond crystals is caused to occur on a heated preferred metal substrate as a result of bringing an activated gas mixture comprising hydrogen and hydrocarbon into contact with the heated metal substrate. The gas mixture is concurrently subjected to microwave energy and a heated tungsten filament and converted to a gas plasma prior to diamond crystal formation or nucleation therefrom on the substrate. Diamond crystals obtained from this method, which is referred to as a chemical vapor deposition method, were found to be about 180 µm in their longer dimension after about 48 hours of the growth process.

JP-A-59-182 300 discloses a method for producing diamond in which a mixture of hydrogen and methane is activated by an incandescent filament such that diamond is deposited onto a substrate being made of metal, thermet or ceramic coated on its surfaces with at least one compound selected from carbides, nitrides, carbonitrides, carboxynitrides, boride, borocarbide and boronitride of metals in group IVa, Va and VIa as well as Si and Al, boron carbide and boron nitride.

A principal object of the invention is to provide an improved chemical vapor deposition process for making diamond crystals of controlled grain size.

It is still another object of the invention to provide a low pressure gas deposition process for producing diamond utilizing an improved substrate on which the diamond crystals are formed or grown.

It is yet another object of this invention to provide an improved nucleation supporting substrate for use in a vapor-liquid-solid chemical vapor deposition process for producing diamond crystal impingement of an activated hydrogen-hydrocarbon gas mixture on a heated substrate.

Another object of the invention is to provide means for patterning a substrate with diamond crystals of the same or differing size.

Another object of the invention is to provide a method for growing diamond on a chemical vapor deposited layer or film of polycrystalline diamond.

Another object is to provide a method for refinement of grain size of polycrystalline diamond by chemical vapor deposition.

Another object of the invention is to provide a method for controlling the grain size of polycrystalline diamond made by a chemical vapor deposition method in which a hydrogen-hydrocarbon gas mixture is activated by an incandescent filament or microwave energy.

A hydrogen-hydrocarbon gas mixture is passed into a chemical vapor deposition reaction chamber where it is activated by exposure to microwave energy or an incandescent tungsten wire filament while in contact with a boron-free substrate structure comprising a surface on which there is an effective amount of a nucleation and growth promoting material which enhances nucleation and growth of diamond crystals.

It has now been discovered that the presence of elemental boron on the boron-free substrate will provide substantially improved results and ability to control with respect to the rate of growth, yield, and size of the diamond crystals formed on the substrate. An improved substrate surface in accordance with this invention comprises a supporting surface which has been treated prior to the deposition process with elemental boron. The boron-free substrate can be in the form of a small strip of a metal foil or a sheet, preferably of a metal which itself is conducive to the formation of diamond crystals thereon in a chemical vapor deposition process. Among such metals are the strong carbide formers, notably the refractory metals, molybdenum, tantalum, silicon and tungsten.

Polycrystalline diamond can also be vapor deposited on graphite or on a substrate of sintered diamond powder or on a substrate of chemical vapor deposited polycrystalline diamond. The sintered or vapor deposited diamond is advantageously treated prior to a further deposition step with elemental boron for the purpose of promoting formation of nucleation sites for subsequent deposition cycles. The presence of even a small amount of elemental boron on the surface of these substrate materials stimulates diamond crystal nucleation on the substrates. The presence of elemental boron on the substrate appears to act as a promoter of diamond crystal nucleation as evidenced by the presence of a large number of nucleation sites when utilized and fewer nucleation sites under similar conditions when absent. Best results were achieved in the practice of this invention when the elemental boron is directly exposed to the luminescent gas mixture. In one preferred embodiment of this invention, the surface of the substrate which is directly exposed to the tungsten wire heater and the flowing gas stream from gas inlet tube, is coated prior to the deposition process with a thin layer of a mixture of certain materials including elemental boron, in finely divided, small particle, or powdered form. The materials become molten and expose a liquid metal layer containing boron to the impinging gas stream.

An improved substrate in accordance with this invention comprises a very thin layer of fine particle material including elemental boron, on a supporting surface where the fine particle layer is directly exposed to the impinging gas stream.

Very small amounts of elemental boron appear to facilitate crystal nucleation. In another embodiment of this invention very fine particle amorphous boron was included in a methanol carrier and coated on the surface of a substrate. The presence of boron resulted in more crystal nucleation as compared to carrying out the process without the presence of boron as described. Uncombined or elemental boron can be added to or applied to the surface of a substrate which is exposed to the luminescent gas mixture so that the boron is also exposed to the gas mixture. As such, the substrate of this invention may be described as a support member, e.g., a refractory metal strip, and elemental boron on at least a portion of the surface of the support member. Elemental boron may be added to the surface as a fine particle layer or utilized with a carrier medium to be coated on the surface of a substrate. It is preferred that the surface of a substrate which is exposed to the gas plasma have boron added to its surface rather than to have boron included in the substrate matrix. It is more advantageous to employ elemental or chemically uncombined boron. As noted, boron particles may be included in a carrier or host medium such as methanol which is then coated on a substrate. Alternatively, boron may be carried in a solid material or matrix which is then associated with a substrate.

Boron is used in the form of elemental boron, crystalline or amorphous. The boron can easily be slurried with a volatile carrier, e.g., lower alcohol such as methanol or ethanol, and then painted or coated on the substrate surface in whatever pattern is desired. It has been found that the boundary between boron carrying areas and boron-free areas is sharp with at least initially, much smaller grain size being seen in the areas treated with boron. It is apparent that utilities which require small grain diamonds can be more easily satisfied through the use of boron coated substrates. For example, abrasive compacts and machine tools can be provided with working areas characterized by small size crystals. The small grain areas or zones can form a pattern of varying shape and dimension which is distinguishable from adjacent large grain zones or grain-free zones. This feature of the invention can be referred to as grain size patterning.

The term "grain size patterning" as used herein means forming patterns or regions distinguished by the grain size of the diamond crystals in the area or region, e.g., regions of small size crystals are distinguished from regions of large size diamond crystals. Those regions of small size crystals are seen as having a substantially higher density of nucleation sites, i.e., more nucleation sites per unit of surface area, and therefore substantially smaller diamond crystals though in larger number.

Surprisingly, the demarcation between boron-carrying and boron-free areas of the substrate is sharp and clear in terms of the diamond grain or crystal size. If nucleation does occur in the boron-free zone, the crystals are clearly larger and easily distinguishable from the small grain diamond which forms on the boron-carrying surface of the substrate.

The nucleation promoting boron treatment can be applied to the substrate by any convenient method. For example, a solution or slurry of boron, e.g., amorphous boron, in a suitable solvent or vehicle can be applied to the surface by means of a roller, a brush or applicator. A lower aliphatic alcohol has been found to be a convenient vehicle. Screen printing is a particular efficacious means of applying the boron in a predetermined pattern or figure. Alternatively boron in powder or particulate form can be applied directly to the substrate by dusting or can be applied in the form of an adherent admixture.

All the above methods may be utilized to provide a presence of boron at the substrate surface.

As described in EP-A-272 418, the addition of boron compounds such as diborane to the gas mixture is ordinarily utilized to introduce an additional element, boron in this instance, into the diamond crystal formed and not to provide boron on a substrate surface. Injection of boron atoms into a diamond crystal significantly changes the electrical characteristics of the diamond crystal. In the present invention providing a presence of elemental boron on the substrate surface where diamond nucleation and growth occurs significantly affects both occurrences, i.e., nucleation and growth.

This invention provides an improved substrate surface in the form of a metal substrate layer containing boron for growing larger diamond crystals. Further, the use of a layer of powder material containing boron powder on the surface of a substrate provides a granular surface exposed to the gas mixture and an exceedingly great increase in the surface area exposed to the gas mixture as well as providing a dramatic increase in diamond nucleation sites, each particle providing a plurality of potential sites. However, a primary feature of this invention is the presence of boron at the nucleating surface to act as a nucleating expeditor or enhancer. An improved substrate combination includes molybdenum foil strip as one part of the combination, and the presence of boron, e.g., as a powder layer as the other part. It is a combination which exposes the supporting surface as well as the diamond nucleation catalyst directly too the hydrogen-hydrocarbon gas mixture. The practices of this invention indicate that boron acts as a crystal nucleation enhancer in solid or liquid form. However, it is believed that it is the actual presence of boron on the substrate which generates the enhancing effect, and the form of its presence is not the significant factor.

This invention provides improved substrates for growing diamond crystals of varying size by means of a chemical vapor deposition process, by incorporating or providing a presence of boron at the diamond crystal nucleation site by the use of fine particle or powdered elemental boron at least as a part of a substrate and preferably in combination with a supporting surface of a refractory metal such as molybdenum.

In general, a chemical vapor deposition apparatus suitable for the practice of this invention comprises a reaction chamber containing a substrate on which diamond will be deposited and a tungsten resistance element, means for delivering a hydrogen-hydrocarbon gas mixture to the chamber, a microwave generator for irradiating the substrate and gas mixture in the vicinity of the substrate and means for controlling the pressure within the reaction chamber.

More particularly, a chemical vapor deposition apparatus comprises a reaction chamber in the form of a quartz tube having a closed end and an opposed open end. The reaction chamber is placed within a microwave chamber or cavity. Enclosed within the reaction chamber are four equally spaced molybdenum support rods arranged in a square configuration with one rod at each corner of a defined square. One pair of diagonally opposite rods support an electrical resistance filament or coil heater between them adjacent the closed end of reaction chamber tube. The other pair of diagonally opposite rods support a substrate therebetween at a position more remote from the closed end of the reaction chamber than the heater. A wide variety of substrate materials are available. Refractory metals, such as molybdenum, rhenium, tantalum, and tungsten are preferred. Other materials suitable for use as a substrate include graphite and diamond. A small diameter quartz gas delivery or inlet tube extends into the reaction chamber generally parallel with but spaced from support rods and adjacent the center of the square defined by the support rods without contacting the heater or the substrate. As the inlet tube extends near the closed end of the reaction chamber, it curves back on itself for a 180° curve so that its exit end terminates adjacent the tungsten heater coil.

As the gas mixture flows from gas inlet tube into reaction chamber, it is caused to become an incandescent gas plasma by being subjected to contact with the heater at incandescent temperature and/or exposure to electromagnetic microwave energy.

The apparatus is provided with an electromagnetic wave energy generator which emits microwave energy into the reaction chamber. In order to focus the microwave energy in a desired region a parabolic reflector can be employed. It is in this region that the gas stream is caused to become a luminescent gas plasma. Components and flow control means to deliver a gas or gas mixture to gas inlet tube can be of the type generally associated with chemical vapor deposition reactors.

A pair of gas storage tanks can be interconnected by means of gas flow control valves to a common conduit, one tank is filled with only hydrogen. The other tank is filled with a mixture of 90% by volume of hydrogen (H₂) gas and 10% by volume of methane (CH₄) gas. By utilizing a mixture of gases in one tank and a sole gas in the other tank, the flow valves can be more easily adjusted to provide smaller and more precise changes in the gas mixture flowing into the reaction chamber. A vacuum pump controls the removal of gases from the reaction chamber and the pressure within the reaction chamber. Electrical power is delivered to the heater which is a wire coil, e.g. of tungsten, tantalum, molybdenum, or rhenium, to raise its temperature to about 2000°C. at which temperature the tungsten wire is incandescent. As the gas mixture passes over the incandescent heater, it may be concurrently subjected to microwave energy from a generator which is focussed by means of a moveable parabolic reflector. Conversely, microwave energy alone may be used to excite the hydrogen-hydrocarbon gas mixture. As described in the aforementioned EP-A-272 418, subjecting the gas flow in the general region between the end of the inlet tube and the substrate concurrently to activation by an incandescent resistance wire heater and microwave energy causes the gas stream to become a luminescent plasma with a high degree of atomic hydrogen in the vicinity of the substrate and produces an increased yield of diamond crystals as well as larger diamond crystals to form on the substrate.

### EXAMPLE 1

A chemical vapor deposition apparatus of the configuration described above was employed in which a molybdenum foil substrate served as a supporting surface for a layer of a mixture of fine particle material comprising the following components, by weight per cent:

| | | |
|---|---|---|
| Palladium | Pd | 62.0% |
| Iron | Fe | 5.5% |
| Nickel | Ni | 15.5% |
| Boron | B | 5.0% |
| Carbon | C | 2.0% |

The flow control valves were adjusted to provide a flow of a gas mixture of 1.0% methane and 99% hydrogen through the gas inlet tube. Reaction chamber was a quartz tube of 5.08 cm (2.0 inches) I.D. An exhaust pump was energized and flow adjusted so that the gas mixture flow rate through the gas inlet was about 55 cm³/min. and the gas pressure in the reaction chamber was maintained at a constant 1.13 kPa (8.5 Torr). A tungsten wire heater formed of tungsten wire of 0.508 mm (0.020 inch) diameter, 2.54 cm (1.0 inch) long, with 18 coils and an I.D. of 3.175 mm (0.125 inch), was energized at a constant electrical power input of 27.3 amperes. A microwave energy generator was energized at its operating power level of 500 watts, and a reflector adjusted so that the gas stream reached peak luminescence adjacent the substrate. The above conditions were maintained for a period of four hours, after which all electrical power was interrupted, gas flow halted and the substrate removed from the reaction chamber. A number of relatively large diamond crystals were mechanically removed from the substrate, several of which were found to have the following general dimensions in micrometers which denotes an advantage of the use of boron as described, as compared to the use of the chemical vapor deposition process to produce diamond crystals, in the absence of boron.
120 x 20 x 30
150 x 70 x 100
105 x 70 x 100
105 x 105 x 40
75 x 75 x 100
100 x 80 x 50
An examination of the substrate revealed that the powder mixture had become molten to form an in situ alloy which then solidified, and diamond nucleation had occurred on the molten metal layer. The diamond crystals were mechanically removed from the metal layer indicating that the liquid metal had not wetted the surface of the diamond crystals to generate a strong bond, and that diamond nucleation had occurred on the surface of or in the liquid metal layer.

### EXAMPLE 2

A molybdenum disk of 1.9 cm (3/4 inch) diameter and 6.85 mm (1/4) inch thickness was polished on one face. A mixture of 0.196 grams of sodium alginate, 0.206 grams of crystalline boron, and 4 grams of water was prepared and screen-printed onto the polished face of the disk. The printing screen was an MEC 12.7 cm x 12.7 cm (5 by 5 inch) screen of 75 µm opening (mesh size 200). The wire diameter was 0.04 mm (1.6 mils) and the angle of the wire mesh to the print stroke was 22.5 degrees. ER resin was used as the screen blocking material. The screen pattern was a square array of 0.254 mm (10 mil) lines with 1.27 mm (50 mil) centers forming an overall diameter of 2.54 cm (1 inch).

The screen printed disk was placed in a 5.08 cm (2 inch) diameter quartz reaction chamber of a CVD apparatus and a mixture of 1 volume percent methane in hydrogen was fed into the reaction chamber at a rate of 55 cc. per minute. Gas pressure was maintained at about (8.5 Torr) 1.13 kPa.

The gas mixture was excited by an incandescent tungsten filament situated about 8 mm above the disk through which a constant current of 25 amperes was fed. The filament was 2.54 cm (1 inch) long formed by winding 18 turns on a 3.175 mm (1/8 inch) diameter mandrel.

The reaction chamber was located inside a 500 watt microwave oven which was run at high power setting. A parabolic aluminum reflector was used to focus the microwave energy into the reaction chamber in vicinity of the disk and heated filament.

The reaction conditions were maintained for 5 hours during which time the temperature of the disk was maintained in the range between 800° and 900°C

Black diamonds nucleated and grew on the printed boron lines. In the unprinted areas diamond-nucleation and growth was random and the density of the diamond grains was much lower. The average diameter of the diamonds was 25.4 µm to 38.1 µm (1 to 1.5 mils).

### EXAMPLE 3

A polycrystalline diamond substrate made by sintering diamond powder under pressure was partially coated with amorphous boron in ethyl alcohol by painting the boron slurry onto one half of the substrate surface with a cotton swab. The alcohol was allowed to evaporate at room temperature in ambient air. The substrate was then placed in a chemical vapor deposition apparatus of the type described above and operated under the following conditions.

Flow Rates: Cross sectional area = 100 cm²
Total = 210 cm³/min
100 H₂ = 175 cm³/min
10% CH₄ in H₂ = 35 cm³/min
Linear Flow rate = 2 cm/minute
Filament = 7.62 mm (0.030") 218-tungsten wire 17.78-2.22 cm (7-7/8") long vertical filament
Filament-substrate separation = 8.5 mm
Filament temperature = 2200°C
Amperes = 52 amps
Volts = 28 volts
Pressure = 1.19 kPa 9 mm Hg (9 torr)
Run time = 70 hours
Growth rate = 1.7 micrometers/h (1.7 x 10⁻⁴cm/h)
Thickness = 112 micrometers (0.0112 cm)
Uncoated diamond - crystal size = 75µm
Boron coated diamond - crystal size <15µm
Examination of the deposited diamond coating showed that the uncoated area of the substrate had large crystals some as large as 1/4 mm across. The average grain size was about 75 micrometers. The boundary between boron coated and the uncoated areas of the substrate was sharp and well defined with no indication of boron transport. The diamond grain size on the boron coated area was 1/2 to 15 micrometers.

The conditions described in Examples 1 through 3 are considered to be representative of conditions suitable for diamond growth according to the present invention. Variation of current, flow rate, voltage, pressure and the like can be utilized to optimize the process for specific results and for techniques in which resistance and microwave excitation are used separately or concurrently.

### Example 4

This example describes the preparation of a multi layer polycrystalline aggregate characterized by decreasing grain size in each successive layer of deposited diamond obtained by recoating the preceeding diamond layer with boron followed by deposition of the next layer of diamond. In each case the diamond of the preceeding layer was the substrate for the following layer, except for the initial layer of diamond which was deposited on a boron treated molybdenum substrate.

The initial molybdenum substrate was sheet 0.381 mm x 3.175 cm x 22.86 cm (0.015 x 1.25 x 9 inches) which had been coated with boron slurried in ethanol. The treated substrate was hung parallel to a tungsten filament which was brought to a temperature of about 2000°C. A mixture of hydrogen and methane (1%) was passed through the system at a flow rate of about 157 cm³ per minute. After a deposition period of determined time the diamond coated substrate was removed from the chamber and recoated with boron as before, then returned to its position in the chamber for deposition of the next layer of diamond. This procedure was repeated several times to provide a series of sequential layers under substantially the same deposition conditions except for the grain size of the preceeding layer of diamond.

Examination of the layers of diamond by optical microscopy showed a detectable reduction in the size of the diamond, grains or crystals making up each successive layer based on the presence of some grains of about 5 micrometers size in the first layer to grains of about 2 to 3 micrometers in the second layer to submicron size grains in subsequent layers.

The procedure of Example 4 was substantially followed except that microwave excitation alone was used under conditions substantially as described in Example 1 in order to demonstrate that the microwave energy and boron treatment were useful for refinement of grain size of successive layers of chemical vapor deposited diamond. Optical microscopic examination of the resulting composite revealed successive diminution of the average grain size as described in Example 4.

## Claims

1. A method for producing diamond by a chemical vapor deposition process, comprising providing a boron-free substrate, treating the surface of said substrate, upon which diamond is to be deposited, prior to the deposition process, with elemental boron to enhance diamond crystal nucleation, and subsequently exciting a mixture of hydrogen and a hydrocarbon gas by exposure to an incandescent refractory metal filament and/or microwave radiation while in contact with said treated substrate surface.

2. The method of claim 1 characterized in that the gas mixture is converted to a luminescent gas plasma by activation by exposure to microwave radiation.

3. The method of claim 1 or 2 characterized in that said elemental boron is applied to the substrate surface in the form of a mixture of particle materials comprising iron, nickel, palladium, boron and carbon.

4. The method of claim 1 or 2 characterized in that the elemental boron is applied to the substrate surface in the form of a slurry of elemental boron in a lower aliphatic alcohol vehicle.

5. The method of anyone of claims 1 to 4 characterized in that said substrate is selected from graphite, sintered diamond powder, tungsten, rhenium, molybdenum, tantalum, niobium and silicon.

## Patentansprüche

1. Ein Verfahren zum Herstellen von Diamant durch einen Prozeß zum chemischen Dampfabscheiden, umfassend
die Schaffung eines borfreien Substrates, Behandeln der Ober-fläche des genannten Substrates, auf der Diamant abge-schieden werden soll, vor dem Abscheidungsprozeß, mit elementarem Bor, um die Kristallkernbildung von Diamant zu fördern und
nachfolgendes Anregen einer Mischung aus Wasserstoff und einem Kohlenwasserstoffgas, indem man sie einem Glühfaden aus hochschmelzendem Metall und/oder Mikrowellenstrahlung aussetzt, während sie sich in Kontakt mit der behandelten Oberfläche des Substrates befindet.

2. Das Verfahren nach Anspruch 1, dadurch gekennzeichnet, daß die Gasmischung durch Aktivierung, indem man sie Mikrowellenstrahlung aussetzt, in ein lumineszentes Gasplasma umgewandelt wird.

3. Das Verfahren nach Anspruch 1 oder 2, dadurch gekennzeichnet, daß das elementare Bor in Form einer Mischung teilchenförmiger Materialien, umfassend Eisen, Nickel, Palladium, Bor und Kohlenstoff, auf die Substratoberfläche aufgebracht wird.

4. Das Verfahren nach Anspruch 1 oder 2, dadurch gekennzeichnet, daß das elementare Bor in Form einer Aufschlämmung von elementarem Bor in einem Träger aus einem niederen aliphatischen Alkohol auf die Substratoberfläche aufgebracht wird.

5. Das Verfahren nach einem der Ansprüche 1 bis 4, dadurch gekennzeichnet, daß das genannte Substrat ausgewählt ist aus Graphit, gesintertem Diamantpulver, Wolfram, Rhenium, Molybdän, Tantal, Niob und Silicium.

## Revendications

1. Procédé de production de diamant par un procédé chimique de dépôt à partir d'une phase vapeur, comprenant la fourniture d'un support exempt de bore, le traitement de la surface dudit support, sur laquelle du diamant doit être déposé, avant le procédé de dépôt, avec du bore élémentaire pour accroître la nucléation des cristaux de diamant, et ensuite l'excitation d'un mélange d'hydrogène et d'un hydrocarbure gazeux par exposition à un filament de métal réfractaire incandescent et/ou un rayonnement hyperfréquence, ledit mélange étant en contact avec ladite surface du support traitée.

2. Procédé selon la revendication 1, **caractérisé** en ce que le mélange gazeux est transformé en un plasma gazeux luminescent par activation par exposition à un rayonnement hyperfréquence.

3. Procédé selon la revendication 1 ou 2, **caractérisé** en ce que ledit bore élémentaire est appliqué à la surface du support sous la forme d'un mélange de matières en particules, comprenant du fer, du nickel, du palladium, du bore et du carbone.

4. Procédé selon la revendication 1 ou 2, **caractérisé** en ce que le bore élémentaire est appliqué à la surface du support sous la forme d'une bouillie de bore élémentaire dans un véhicule constitué d'un alcool aliphatique inférieur.

5. Procédé selon l'une quelconque des revendications 1 à 4, **caractérisé** en ce que ledit support est choisi parmi le graphite, la poudre de diamant frittée, le tungstène, le rhénium, le molybdène, le tantale, le niobium et le silicium.
